# EUROPEAN PATENT APPLICATION

(11) **EP 2 549 649 A1**
(43) Date of publication of application: **23.01.2013**
(21) Application number: 12177543.1
(22) Date of filing: 23.07.2012
(51) Int. Cl.: H03K 17/082

(54) **Actively clamped transistor circuit**

(30) Priority: 21.07.2011 DE 102011079569
(71) Applicant: HS Elektronik Systeme GmbH, 86720 Nördingen (DE)
(72) Inventor: Greither, Markus, 86154 Augsburg (DE)
(74) Representative: Tomlinson, Kerry John

(57) **Abstract**

An active clamped transistor circuit (100, 200) comprises a transistor (110) and a bi-directional transient voltage suppression (TVS) diode (120) connected across a gate (116) and a drain (112) of said transistor.

## Description

### BACKGROUND

The present disclosure is directed to transistor controls, and more particularly to an active clamp circuit for use with a transistor.

Modern vehicle power control systems typically use switching transistors, such as metal oxide semiconductor field effect transistors (MOSFETs) to control power distribution throughout the vehicle. In such a configuration, the transistors are protected from overvoltages using clamping circuits that prevent the voltage across the transistor from exceeding a clamp value. Clamp circuits can be either active clamp circuits, that affect the circuit only when the clamp voltage is exceeded, or passive clamp circuits that have an ongoing effect on the circuit.

Active clamp circuits for transistors shunt power from a transistor drain to the transistor gate when a drain to source voltage of the transistor exceeds a threshold voltage. When power is shunted to the transistor gate, the transistor is turned on, thereby allowing power to flow across the transistor and preventing excessive drain to source voltages.

A typical active clamp circuit includes either a Zener diode or a unidirectional transient voltage suppression (TVS) diode in series with a forward blocking rectifier diode. The Zener diode or TVS diode and the forward blocking rectifier diode are connected between the gate and drain of the transistor. In such a configuration, the Zener diode allows current to pass when the voltage exceeds the Zener breakdown voltage, and the forward blocking diode prevents reverse current flow when the transistor is turned on.

### SUMMARY

An active clamped transistor circuit includes a transistor and a transient voltage suppression (TVS) diode connected across a gate and a drain of said transistor.

An active clamped transistor circuit comprises a transistor; and a bi-directional transient voltage suppression (TVS) diode connected across a gate and a drain of said transistor.

A power distribution system includes a plurality of power distribution switches, each having a transistor and a TVS diode connected across a gate and a drain of the transistor.

A method for actively clamping a transistor drain to source voltage includes the step of shunting excess current from a drain node to a gate node of a transistor using a TVS diode when a drain to source voltage exceeds a threshold, thereby ensuring that the transistor does not enter an avalanche breakdown state.

These and other features of the present invention can be best understood from the following specification and drawings, the following of which is a brief description.

### BRIEF DESCRIPTION OF THE DRAWINGS

Figure 1 illustrates an example aircraft power distribution system
Figure 2 illustrates an active clamped transistor circuit.
Figure 3 illustrates another active clamped transistor circuit.

### DETAILED DESCRIPTION

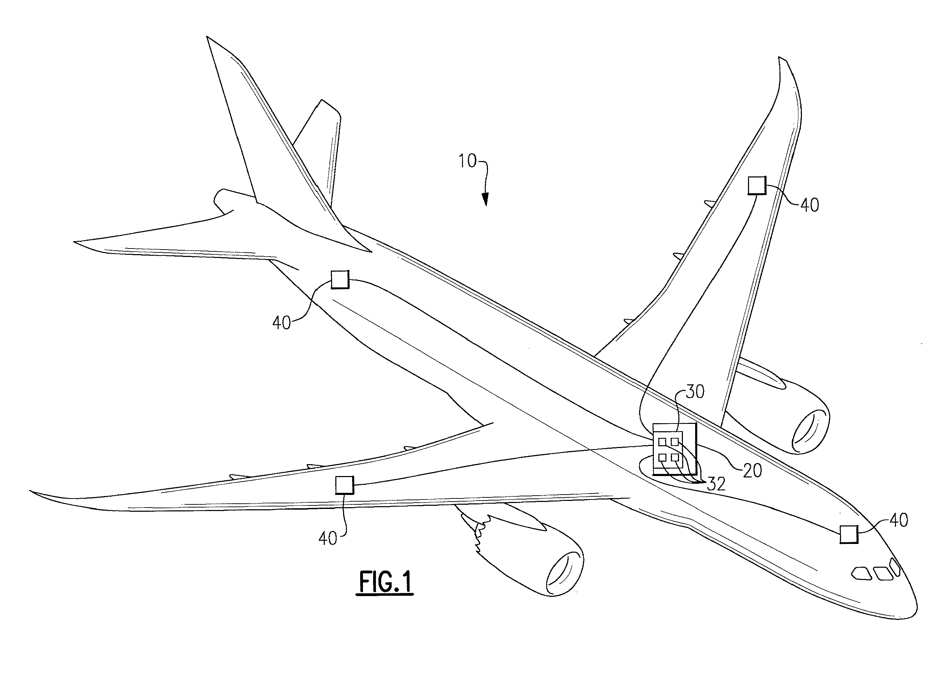

Figure 1 illustrates an aircraft 10, having an onboard power distribution system 20. The onboard power distribution system 20 includes a controller 30 capable of controlling the distribution of power through the aircraft to multiple different electronic components 40. Included in the controller 30 are multiple power switch circuits 32. While Figure 1 illustrates four power switch circuits 32, a practical implementation of the power distribution system 20 would include significantly more power switch circuits 32.

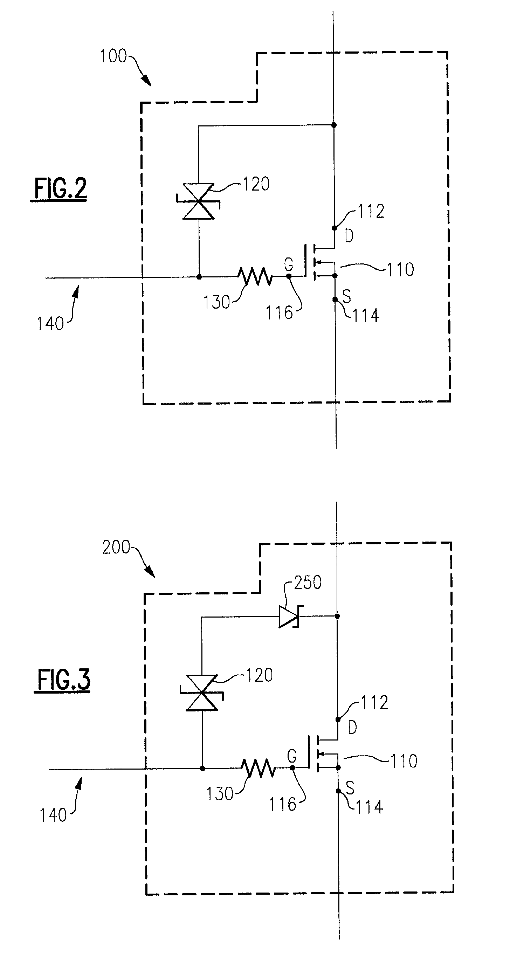

Figure 2 illustrates an active clamped transistor circuit 100 including a transistor 110. The active clamped transistor circuit 100 is arranged to operate as a power switch, such as the power switch circuit 32 of Figure 1. The transistor 110 has a drain node 112, a source node 114 and a gate node 116. A control signal input 140 passes through a conditioning resistor 130 and controls the operational state of the transistor 110. The conditioning resistor 130 ensures that the control signal received by the transistor 110 is suitable to control the transistor 110. When a signal is present on the control signal input 140 the transistor 110 is on and allows drain to source power flow, and when no signal is present on the control signal input 140 the transistor 110 is off and prohibits drain to source power flow. The control signal input 140 originates from the controller 30 (illustrated in Figure 1).

Electronic components, such as diodes and transistors that block current flow include a maximum voltage rating under which the component can continue to block current flow. When the voltage rating is exceeded, the electrical component breaks down and begins to allow current flow. The maximum voltage rating is referred to as an avalanche breakdown potential, and when the avalanche breakdown potential is exceeded, the electrical component is said to be in the avalanche breakdown state. Some components, such as transient voltage suppression (TVS) diodes, are designed to operate within the avalanche breakdown state and can transition between normal mode operation and avalanche breakdown operation with no damage to the component. Other electrical components, such as metal oxide semiconductor field effect transistors (MOSFETs) can be damaged or destroyed if they enter the avalanche breakdown state.

In the example of Figure 2, a bi-directional TVS diode 120 connects the conditioning resistor 130 to the drain node 112 of the transistor 110. The transistor 110 may be a MOSFET. The bi-directional TVS diode 120 allows power to flow from the drain node 112 and through the bi-directional TVS diode 120 when the drain to gate voltage of the transistor 110 exceeds the avalanche breakdown potential of the bi-directional TVS diode 120. When the drain to gate voltage no longer exceeds the avalanche breakdown potential of the bi-directional TVS diode 120, the bi-directional TVS diode 120 resets and returns to the default state of blocking current flow. Due to the drain to gate connection of the bi-directional TVS diode 120, the TVS diode does not need to be sized to absorb all of the clamp energy during active clamping. Rather, the active clamp transistor circuit 100 of Figure 2 utilizes the transistor 110 to absorb the majority of the clamp energy.

The illustrated bi-directional TVS diode 120 allows current flow in either direction when the avalanche breakdown potential is exceeded. Additionally, the bi-directional TVS diode 120 provides a significant switching speed benefit over unidirectional TVS diode/rectifier diode and Zener diode/rectifier diode circuits while the circuit is operating at low temperatures. This advantage is partially offset by a significantly higher cost of bi-directional TVS diodes relative to uni-directional TVS diode/rectifier diode or Zener diode/rectifier diode circuits.

The power flow across the bi-directional TVS diode 120 during an overvoltage provides a control signal to the gate node 116 through the conditioning resistor 130. In this way, the transistor 110 is turned on when the drain to gate voltage of the transistor 110 exceeds the avalanche breakdown potential of the bi-directional TVS diode 120. The bi-directional TVS diode 120 prevents current flow at all other times, effectively having no impact on the circuit when no overvoltage is present.

Figure 3 illustrates a second active clamped transistor circuit 200 including a transistor 110. The active clamped transistor circuit 200 of Figure 3 includes identical elements to the example of Figure 2, with like numerals indicating like elements. Additionally, the active clamped transistor circuit of Figure 3 includes a Zener diode 250, connected between the bi-directional TVS diode 120 and the drain node 112. The Zener diode 250 is used to adjust the breakdown voltage of the bi-directional TVS diode 120.

If the active clamp circuit (the bi-directional TVS diode 120 in the example of Figure 2) in a power switch has a slower response time than the switching rate of the transistor 110, the transistor 110 can temporarily enter an avalanche breakdown state at the start of an overvoltage. Entering the avalanche breakdown state occurs because the transistor 110 switches to the avalanche breakdown state faster than the active clamp circuit opens the transistor 110 to prevent the overvoltage when the transistor 110 switch speed is faster than the response time of the active clamp circuit. If the transistor 110 enters the avalanche breakdown state, the transistor 110 can be damaged or destroyed. Thus, the switching rate of the transistor 110 is effectively limited to greater than the response time of the active clamp circuit. By ensuring that the bi-directional TVS diode 120 of Figure 2 responds faster than the transistor 110 can change states, the bi-directional TVS diode 120 will always activate the transistor 110 before the transistor 110 enters the avalanche breakdown state. The faster response time of the bi-directional TVS diode 120 allows the active voltage clamping circuit of Figure 2 to provide an active clamp for a state of the art MOSFET 110 that has a fast switching speed. The active clamped transistor circuits 100 and 200 are characterized by an absence of rectifier diodes.

Although the above active clamp circuit is described with regards to aircraft power distribution, it is understood that the disclosed circuit could be used in conjunction with any transistor switching circuit and still fall within the above disclosure.

Although an example embodiment has been disclosed, a worker of ordinary skill in this art would recognize that certain modifications would come within the scope of this disclosure. For that reason, the following claims should be studied to determine the true scope and content of this disclosure.

## Claims

1. An active clamped transistor circuit (100, 200) comprising:
a transistor (110); and
a bi-directional transient voltage suppression (TVS) diode (120) connected across a gate (116) and a drain (112) of said transistor.

2. The active clamped transistor circuit of claim 1, further comprising a conditioning resistor (130) connecting said transistor gate (116) to a node of said bi-directional TVS diode (120).

3. The active clamped transistor circuit of claim 2, wherein said bi-directional TVS diode (120) and said conditioning resistor (130) are connected in series.

4. The active clamped transistor circuit of claim 1, 2 or 3, wherein said transistor (110) is a metal oxide semiconductor field effect transistor (MOSFET).

5. The active clamped transistor circuit of claim 1, 2, 3 or 4, wherein a response time of said bi-directional TVS diode (120) is less than a switching time of said transistor (110).

6. The active clamped transistor circuit of any preceding claim, wherein the active clamped transistor circuit is **characterized by** an absence of rectifier diodes.

7. The active clamped transistor circuit of any preceding claim, further comprising a Zener diode (250) connecting said bi-directional TVS diode (120) to said drain (112) of said transistor (110).

8. A power distribution system (20) comprising:
a plurality of power distribution switches (32), each of said power distribution switches comprising an active clamped transistor circuit (100, 200) as claimed in any preceding claim.

9. A method for actively clamping a transistor drain to source voltage comprising the step of shunting excess current from a drain node (112) to a gate node (116) of a transistor (110) using a bi-directional transient voltage suppression (TVS) diode (120) when a drain to source voltage exceeds a threshold, thereby ensuring that said transistor does not enter an avalanche breakdown state.

10. The method of claim 9, wherein said step of shunting excess current from a drain node to a gate node of a transistor using a bi-directional TVS diode further comprises passing said excess current through a Zener diode (250) connecting said bi-directional TVS diode to said drain node.
